# EUROPÄISCHE PATENTSCHRIFT

(11) **EP 1 045 628 B1**
(45) Veröffentlichungstag und Bekanntmachung des Hinweises auf die Patenterteilung: **20.10.2004**
(21) Anmeldenummer: 00107277.6
(22) Anmeldetag: 04.04.2000
(51) Int. Cl.: H05K 5/02, H05K 5/00

(54) **Quaderförmiges Einbaugehäuse mit in Richtung der Hochachse kleinster Dimension**
Parallelepipedal housing with a smaller size along its vertical axis
Boitier parallèlépipèdique avec une plus petite dimension selon l'axe vertical

(30) Priorität: 16.04.1999 DE 29906726 U
(43) Veröffentlichungstag der Anmeldung: 18.10.2000
(73) Patentinhaber: SIEMENS AKTIENGESELLSCHAFT, 80333 München (DE)
(72) Erfinder: Kirner, Herbert, Dipl.-Ing. (FH), 78052 Villingen-Schwenningen (DE)

(56) Entgegenhaltungen:
- DE-U- 29 801 996
- US-A- 5 031 791
- US-A- 5 208 734
- US-A- 5 423 605
- PATENT ABSTRACTS OF JAPAN vol. 1999, no. 12, 29. Oktober 1999 (1999-10-29) & JP 11 182107 A (TAMURA ELECTRIC WORKS LTD), 6. Juli 1999 (1999-07-06)

## Beschreibung

Die Erfindung betrifft ein Einbaugehäuse mit in Richtung der Hochachse kleinster Dimension, bestehend aus einem Deckelteil, einem Bodenteil und einer Frontwand, wobei das Deckelteil und das Bodenteil zu einem an einer Stirnseite offenen Gehäusebauteil verbindbar sind und die Frontwand, die offene Stirnseite des Gehäusebauteils abdeckend, an dem Gehäusebauteil befestigbar ist; (vgl. z.B. US-A-5 031 791).

Ist ein Gerät für den Einbau beispielsweise in ein Armaturenbrett eines Kraftfahrzeuges vorgesehen, so steht bei dem gattungsgemäß vorgesehenen Grundriß des Gerätes im allgemeinen nur eine Schmalseite beziehungsweise eine Stirnseite für Anzeigen und Betätigungen zur Verfügung. Das heißt, die entsprechenden Anzeige- und Betätigungsmittel sind einer auch den ästhetischen Belangen des Gerätes gerecht werdenden Frontwand oder Frontblende zugeordnet. Die übrigen Seitenwände des Gerätes sowie ein Deckel und ein Boden können im Falle eines Einbaugerätes, welchem eine im wesentlichen formschlüssige Aufnahme, beispielsweise in einem Armaturenbrett zugeordnet ist, eine als Staub- und Griffschutz sowie als elektromagnetischer Schirm dienende Hülle bilden, deren Blechstärke gering sein kann, was eine Optimierung des schnitt- und biegetechnischen Fertigungsaufwandes und eine maximale Nutzung des durch die Einbaumaße vorgegebenen Bauraumes ermöglicht. Das heißt, daß andererseits eine Versteifung des Einbaugehäuses durch innere Strukturen des Gerätes erfolgen muß, beispielsweise durch eine quer zur Hochachse des Gerätes angeordnete, Bauelemente und Baugruppen tragende metallische Platine oder Leiterplatte, gegebenenfalls aber auch durch geeignete zusätzliche Verstrebungen.

Die Aufgabe der vorliegenden Erfindung besteht darin, durch geeignete Ausgestaltung von Deckelteil, Bodenteil und Frontwand die Anzahl der Bauteile für die Bildung des Einbaugehäuses und den Aufwand für die Montage, beispielsweise einer Leiterplatte, zu reduzieren und dadurch die Maßhaltigkeit, insbesondere des Gehäusebauteils in Bezug auf die Lage der Frontwand zu einer im Gehäusebauteil befestigen Leiterplatte zu verbessern sowie durch Vermeiden oder in geeigneter Weise Abdecken von Öffnungen in dem Gehäusebauteil eine ausreichend gute elektromagnetische Abschirmung zu schaffen.

Die Lösung der Aufgabe beschreibt der Anspruch 1. Vorteilhafte Ausgestaltungen der Erfindung stellen die Unteransprüche dar.

Bei der gefundenen Lösung ist als Vorteil besonders hervorzuheben, daß das Deckelteil, das Bodenteil und die Frontwand ohne zusätzliche Bauteile verwenden zu müssen lediglich durch Zusammenstecken zu einem selbsttragenden Einbaugehäuse zusammengefügt werden können, das heißt, daß Toleranzadditionen minimiert und somit die aufgabengemäß geforderte Maßhaltigkeit gewährleistet ist. Hinzu kommt, daß die Befestigungsmittel für die Frontwand und eine Leiterplatte nur an ein und demselben Bauteil, in diesem Falle an dem Deckelbauteil, ausgebildet sind. Dabei stellt die zusätzliche Nutzung der für die Befestigung des Bodenteils an dem Deckelteil vorgesehenen Zungen als Befestigungselemente für eine Leiterplatte eine besonders vorteilhafte Weiterbildung der Erfindung dar. Erwähnenswert ist ferner, daß die gefundene Lösung mit einem Minimum an Einschnitten und Durchbrüchen in den Wänden des Einbaugehäuses auskommt und diese fertigungsbedingten Öffnungen nach dem Zusammenfügen des Einbaugehäuses durch geeignetes Verschachteln der einzelnen Bauteile und eine entsprechend verbreiterte Ausbildung der Riegel weitgehend abgedeckt sind.

Im folgenden sei die Erfindung anhand der beigefügten Zeichnungen ausführlicher beschrieben. Es zeigen:
- Figur 1: eine Übersichtsdarstellung des erfindungsgemäßen Einbaugehäuses in einer perspektivischen Untersicht von der Rückseite,
- Figur 2: teilweise aufgebrochene Seitenansichten von Deckelteil, Bodenteil und Frontwand in einer der Montage entsprechenden Zuordnung der Bauteile zueinander,

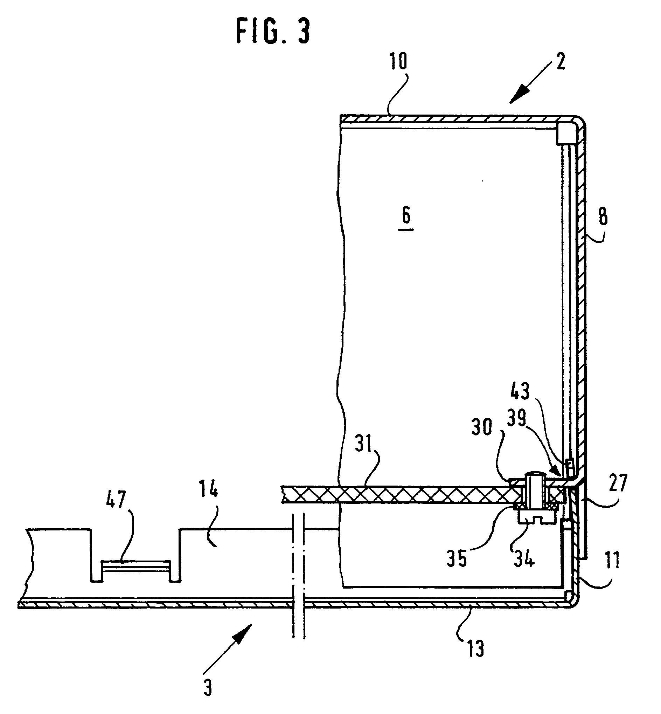

- Figur 3: einen Schnitt gemäß der Schnittlinie A in Figur 2, nachdem Deckelteil und Bodenteil zusammengefügt sind.

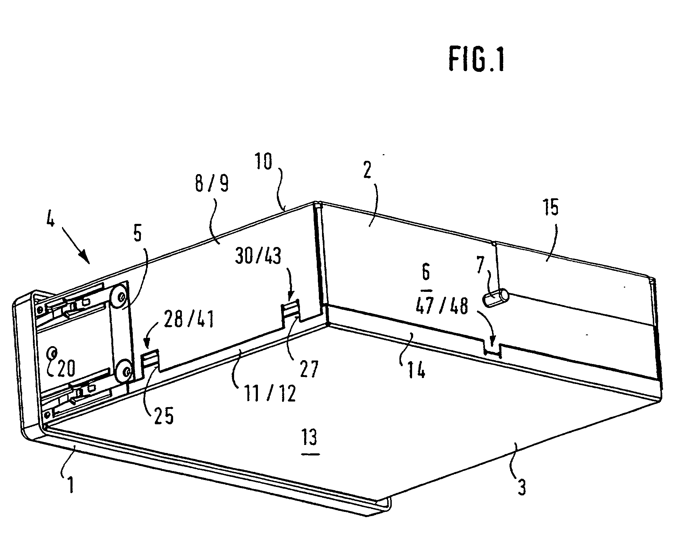

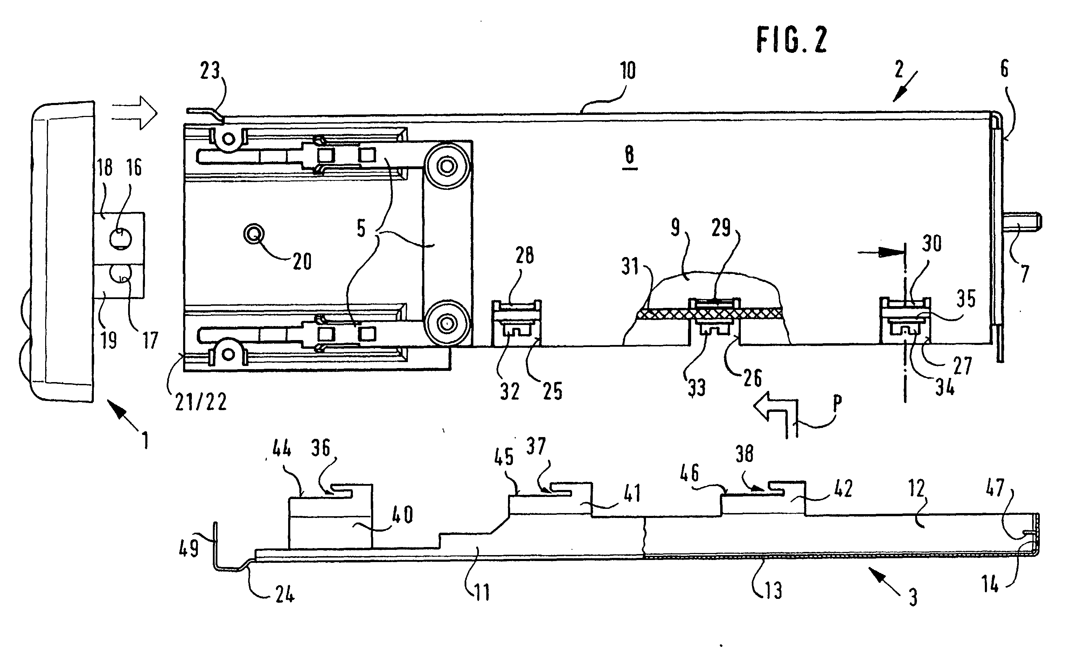

In der Übersichtsdarstellung, Figur 1, ist mit 1 eine vorzugsweise aus Kunststoff hergestellte Frontwand eines gattungsgemäßen Einbaugehäuses bezeichnet. Ein Deckelteil 2 und ein Bodenteil 3, die aus Stahlblech hergestellt sind, bilden ein weitgehend geschlossenes, selbsttragendes Gehäusebauteil 4. Der Befestigung des Einbaugehäuses in einem Einbaufach beziehungsweise einer geeigneten Öffnung in einem Armaturenbrett dienen in an sich bekannter Weise paarweise ausgebildete und an dem Einbaugehäuse seitlich befestigte, federnde Krallen, von denen ein als u-förmiges Bauteil ausgebildetes Krallenpaar in den Figuren 1 und 2 mit 5 bezeichnet ist. Ein an der Rückwand 6 des Deckelteils 2 befestigter Gewindebolzen 7 dient im wesentlichen der Schwingungssicherung des Einbaugehäuses im eingebauten Zustand. Mit 8, 9 sind die parallelen Seitenwände des Deckelteils 2 bezeichnet; 10 stellt die Deckelplatte des Deckelteils 2 dar. Das mit dem Deckelteil 2 verbundene Bodenteil 3 weist ebenfalls Seitenwände 11, 12, eine Bodenplatte 13 und eine Rückwand 14 auf. Eine mit dem Deckelteil 2 verbundene, gegebenenfalls plombierbare Haube 15 dient der Abdeckung einer für das Setzen von Steckern vorgesehenen Freisparung im Deckelteil 2.

Wie aus der Figur 2 ersichtlich ist, sind an der Frontwand 1 mit Bohrungen 16 und 17 versehene Lappen 18 und 19 federnd angeformt. Diesen sind in den Seitenwänden 8, 9 des Deckelteils 2 geeignete Einzüge zugeordnet, von denen einer, dessen nach außen weisende Innenseite in den Figuren 1 und 2 dargestellt ist, mit 20 bezeichnet ist. Die Lappen 18, 19 und die den Lappen 18, 19 zugeordneten Einzüge 20 stellen somit die Rastmittel dar, mit denen die Frontwand 1 mit dem Gehäusebauteil 4 verbindbar ist. Dabei stützt sich im verrasteten Zustand die Frontwand 1 an den Stirnflächen 21, 22 der Seitenwände 8, 9 des Deckelbauteils 2 ab und übergreift beziehungsweise umgreift, wie auch aus der Figur 1 ersichtlich ist, das Gehäusebauteil 4 frontseitig. Abkröpfungen 23 und 24 am Deckelteil 2 und am Bodenteil 3 dienen der Versteifung des jeweiligen Bauteils an dessen der Frontwand 1 zugewandten Stirnseite. Mit 25, 26 und 27 sind drei von vorzugsweise vier im Deckelteil 2 zur Bildung von Zungen 28, 29 und 30 angebrachte Einschnitte bezeichnet. Die Zungen 28, 29, 30 liegen in einer zur Deckelplatte 10 parallelen Ebene und dienen unter Verwendung von Schrauben 32, 33, 34 und Zwischenlegscheiben, von denen eine mit 35 bezeichnet ist, der Befestigung einer in dem betreffenden Gerät vorgesehenen Leiterplatte 31. Außerdem dienen die Zungen 28, 29, 30 der vorzugsweise spielfreien Verbindung des Bodenteils 3 mit dem Deckelteil 2, indem sie mit an den Seitenwänden 11, 12 des Bodenteils 3 oder unmittelbar aus der Bodenplatte 13 des Bodenteils 3 herausgeformten, mit geeigneten Schlitzen 36, 37, 38 und 39 versehenen Riegeln 40, 41, 42 und 43 beim Zusammenfügen von Deckelteil 2 und Bodenteil 3 in Wirkverbindung treten. Dabei sind die Riegel 40, 41, 42, 43 derart gestaltet, daß in der Verlängerung der Schlitze 36, 37, 38, 39 Schultern 44, 45 und 46 ausgebildet sind, die bei der gemäß des Pfeils P bajonetartigen Montagebewegung zwischen dem Bodenteil 3 und dem Deckelteil 2 zunächst ein Auflegen der Zungen 28, 29, 30 auf den Schultern 44, 45, 46 und nachfolgend ein Verschieben in die Fügeposition gestatten. Als zusätzliche Fixierung kann, insbesondere wenn beispielsweise nur zwei Riegel/Zungen-Verbindungen für das Bodenteil 3 vorgesehen sind, an der Rückwand 14 des Bodenteils 3 eine Zunge 47 angeformt sein, welcher ein in der Rückwand 6 des Deckelteils 2 ausgebildeter Schlitz 48 zugeordnet ist. Das Ausführungsbeispiel weist außerdem ein mit 49 bezeichneter, am Bodenteil 3 angeformter Schenkel auf, mittels dessen, falls erforderlich, das Bodenteil an der Frontwand 1 unter Verwendung eine plombierbaren Schraubverbindung befestigbar ist.

Der Vollständigkeit halber sei noch erwähnt, daß in dem in Figur 2 dargestellten Montagezustand, das heißt bei montierter Leiterplatte 31, das Gerät, was die Funktionen anbelangt, in vollem Umfang prüffähig ist und lediglich noch durch Anbringen des Bodenteils 3 und der Frontwand 1 komplettiert werden muß. Außerdem ist hervorzuheben, daß das unmittelbare gegenseitige Abstützen von Deckelteil 2 und Bodenteil 3 auch bei groben Fertigungstoleranzen eine ausreichend gute Maßhaltigkeit bezüglich der Bauhöhe ergibt, was insbesondere für das Anbringen der Frontwand 1 von Bedeutung ist. Mit der Neuerung wird ferner, ohne daß zusätzliche Bauteile oder Versteifungen verwendet werden, im Bereich der Seitenwände eine hohe, für die Handhabung des Gerätes vorteilhafte Griffstabilität erzielt.

## Patentansprüche

1. Quaderförmiges Einbaugehäuse mit in Richtung der Hochachse kleinster Dimension, bestehend aus einem Deckelteil, einem Bodenteil und einer Frontwand, wobei das Deckelteil und das Bodenteil zu einem an einer Stirnseite offenen Gehäusebauteil verbindbar sind und die Frontwand, die offene Stirnseite des Gehäusebauteils abdeckend, an dem Gehäusebauteil befestigbar ist, wobei
zur Bildung des Gehäusebauteils (4) an einer Deckelplatte (10) des Deckelteils (2) zwei sich parallel gegenüberliegende Seitenwände (8, 9) rechtwinklig ausgebildet sind, wobei
unmittelbar aus den Seitenwänden (8, 9) und jeweils gegen eine gegenüberliegende Seitenwand (8 bzw. 9) weisende Zungen (28, 29, 30) herausgeformt sind und wobei
an einer Bodenplatte (13) des Bodenteils (3) Riegel (40, 41, 42, 43) derart ausgebildet sind, daß in paralleler Zuordnung zu den Seitenwänden (8, 9) des Deckelteils (2) an dem Bodenteil (3) Schultern (44, 45, 46) mit zur Bodenplatte (13) parallelen, der Stärke der Zungen (28, 29, 30) entsprechenden Schlitzen (36, 37, 38, 39) angeformt sind.

2. Einbaugehäuse nach Anspruch 1,
**dadurch gekennzeichnet,**
**daß** die Zungen (36, 37, 38, 39) im wesentlichen in einer Ebene ausgebildet sind und
**daß** die Zungen (36, 37, 38, 39) derart verlängert sind, daß sie der Befestigung einer Leiterplatte (31) dienen, wobei die Leiterplatte (31) von den Seitenwänden (8, 9) jeweils wenigstens einen der Stärke der Riegel (40, 41, 42, 43) entsprechenden Abstand aufweist.

3. Einbaugehäuse nach Anspruch 1,
**dadurch gekennzeichnet,**
**daß** die Frontwand (1) mittels an den Seitenwänden (8, 9) und der Frontwand (1) ausgebildeten Rastmitteln (16, 17, 18, 19, 20) mit dem Gehäusebauteil (4) verbindbar ist.

4. Einbaugehäuse nach Anspruch 1,
**dadurch gekennzeichnet,**
**daß** an dem Bodenteil (3) zusätzlich Mittel (49) für eine lösbare Verbindung mit der Frontwand (1) ausgebildet sind und
**daß** die Riegel (40, 41, 42, 43) derart an dem Bodenteil (3) angeformt sind,
**daß** das Bodenteil (3) nach dem Lösen der Verbindung mit der Frontwand (1) außer Eingriff mit den Zungen (28, 29, 30) bringbar ist.

5. Einbaugehäuse nach Anspruch 1,
**dadurch gekennzeichnet,**
**daß** an dem Deckelteil (2) eine die Seitenwände (8, 9) und die Deckelplatte (10) verbindende Rückwand (6) ausgebildet ist,
**daß** an der Bodenplatte (13) des Bodenteils (3) parallel Seitenwände (11, 12) mit daran ausgebildeten Riegeln (41, 42, 43) und eine Rückwand (14) rechtwinklig angeformt sind derart, daß sich beim Zusammenfügen von Deckelteil (2) und Bodenteil (3) die Seitenwände (8, 9, 11, 12) und die Rückwände (6, 14) überlappen, wobei die Seitenwände (11, 12) des Bodenteils (3) zwischen den Seitenwänden (8, 9) des Deckelteils (2) angeordnet sind und die Rückwand (14) des Bodenteils (3) die Rückwand (6) des Deckelteils (2) außen übergreift.

## Claims

1. Cuboid built-in housing having its smallest dimension in the direction of the vertical axis, comprising a cover part, a base part and a front wall, in which case the cover part and the base part can be connected to form a housing component whose end face is open, and the front wall, which covers the open end face of the housing component, can be attached to the housing component, wherein
two mutually parallel, opposite side walls (8, 9) are formed at right angles on a cover plate (10) of the cover part (2) in order to form the housing component (4) ,
wherein tongues (28, 29, 30), which point directly out of the side walls (8, 9) and in each case towards an opposite side wall (8 or 9) are formed, and
wherein bolts (40, 41, 42, 43) are formed on a base plate (13) of the base part (3) such that shoulders (44, 45, 46) with slots (36, 37, 38, 39) which are parallel to the base plate (13) and correspond to the thickness of the tongues (28, 29, 30) are integrally formed on the base part (3) parallel to the side walls (8, 9) of the cover part (2).

2. Built-in housing according to Claim 1,
**characterized**
**in that** the tongues (36, 37, 38, 39) are essentially formed on one plane, and
**in that** the tongues (36, 37, 38, 39) are lengthened such that they are used for the attachment of a printed circuit board (31), wherein the printed circuit board (31) is in each case separated from the side walls (8, 9) by a distance which corresponds at least to the thickness of the bolts (40, 41, 42, 43).

3. Built-in housing according to Claim 1,
**characterized**
**in that** the front wall (1) can be connected to the housing component (4) by latching means (16, 17, 18, 19, 20) which are formed on the side walls (8, 9) and on the front wall (1).

4. Built-in housing according to Claim 1,
**characterized**
**in that** means (49) for detachable connection to the front wall (1) are additionally formed on the base part (3), and
**in that** the bolts (40, 41, 42, 43) are integrally formed on the base part (3) such that the base part (3) can be disengaged from the tongues (28, 29, 30) once the connection to the front wall (1) has been released.

5. Built-in housing according to Claim 1,
**characterized**
**in that** a rear wall (6) which connects the side walls (8, 9) and the cover plate (10), is formed on the cover part (2),
**in that** side walls (11, 12) with bolts (41, 42, 43) formed on them and a rear wall (14) are integrally formed at right angles on the base plate (13) of the base part (3), such that, when the cover part (2) and the base part (3) are joined together, the side walls (8, 9, 11, 12) and the rear walls (6, 14) overlap, wherein the side walls (11, 12) of the base part (3) are arranged between the side walls (8, 9) of the cover part (2), and the rear wall (14) of the base part (3) engages over the rear wall (6) of the cover part (2) on the outside.

## Revendications

1. Boîtier encastrable en forme de parallélépipède, ayant sa plus petite dimension dans le sens de la hauteur et composé d'une partie couvercle, d'une partie fond et d'une face avant, où la partie couvercle et la partie fond peuvent être assemblées pour former un module de boîtier ouvert sur une face frontale et où la face avant, qui recouvre la face frontale ouverte du module de boîtier, peut être fixée sur le module de boîtier,
dans lequel, pour former le module de boîtier (4), deux parois latérales (8, 9) rectangulaires se faisant face sont prévues en parallèle sur une plaque de couverture (10) de la partie couvercle (2),
dans lequel des languettes (28, 29, 30) sont dégagées directement des parois latérales (8, 9) et sont tournées vers une paroi latérale (8 et, respectivement, 9) leur faisant face et
dans lequel, sur une plaque de base (13) de la partie fond (3), des verrous (40, 41, 42, 43) sont aménagés de telle sorte que, en concordance parallèle avec les parois latérales (8, 9) de la partie couvercle (2), des épaulements (44, 45, 46) sont formés sur la partie fond (3) avec des fentes (36, 37, 38, 39), parallèles à la plaque de base (13) et correspondant à l'épaisseur des languettes (28, 29, 30).

2. Boîtier encastrable selon la revendication 1
**caractérisé par le fait**
**que** les languettes (36, 37, 38, 39) sont formées, pour l'essentiel, dans un même plan et
**que** les languettes (36, 37, 38, 39) sont prolongées de telle manière qu'elles servent à la fixation d'une carte à circuits imprimés (31), la carte à circuits imprimés (31) étant à une distance des parois latérales (8, 9) correspondant, dans chaque cas, au moins à l'épaisseur des verrous (40, 41, 42, 43).

3. Boîtier encastrable selon la revendication 1
**caractérisé par le fait**
**que** la face avant (1) peut être fixée au module de boîtier (4) à l'aide de moyens d'encliquetage (16, 17, 18, 19, 20) formés sur les parois latérales (8, 9) et sur la face avant (1).

4. Boîtier encastrable selon la revendication 1
**caractérisé par le fait**
**que**, sur la partie fond (3), en plus, sont formés des moyens (49) permettant une fixation démontable avec la face avant (1) et
**que** les verrous (40, 41, 42, 43) sont formés sur la partie fond (3) de telle manière que la partie fond (3) peut, une fois que la fixation avec la face avant (1) a été libérée, être dégagée des languettes (28, 29, 30).

5. Boîtier encastrable selon la revendication 1
**caractérisé par le fait**
**que**, sur la partie couvercle (2), est formée une paroi arrière (6) reliant les parois latérales (8, 9) et la plaque de couverture (10),
**que**, sur la plaque de base (13) de la partie fond (3), sont formées en angle droit des parois latérales parallèles (11, 12) avec des verrous (41, 42, 43), qui y sont formés, et une paroi arrière (14) de telle manière que, lors de l'assemblage de la partie couvercle (2) et de la partie fond (3), les parois latérales (8, 9, 11, 12) et les parois arrières (6, 14) se chevauchent, les parois latérales (11, 12) de la partie fond (3) étant disposées entre les parois latérales (8, 9) de la partie couvercle (2) et la paroi arrière (14) de la partie fond (3) recouvrant la paroi arrière (6) de la partie couvercle (2) de l'extérieur.
